(19) **Europäisches Patentamt**
**European Patent Office**
**Office européen des brevets**

(11) **EP 3 425 417 B1**

(12) **EUROPÄISCHE PATENTSCHRIFT**

(45) Veröffentlichungstag und Bekanntmachung des Hinweises auf die Patenterteilung:
**27.08.2025 Patentblatt 2025/35**

(21) Anmeldenummer: **17179493.6**

(22) Anmeldetag: **04.07.2017**

(51) Internationale Patentklassifikation (IPC):
***G01R 33/54*** *(2006.01)*

(52) Gemeinsame Patentklassifikation (CPC):
**G01R 33/543;** G01R 33/385; G01R 33/56341

(54) **OPTIMIERUNG EINER ZEITLICHEN ABFOLGE EINER STEUERUNGSSEQUENZ FUER EIN MAGNETRESONANZGERÄT**

OPTIMISATION OF A TEMPORAL SEQUENCE OF COMMANDS FOR A MAGNETIC RESONANCE APPARATUS

OPTIMISATION D'UNE SÉQUENCE TEMPORELLE D'UNE SÉQUENCE DE COMMANDE POUR UN APPAREIL DE RÉSONANCE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**09.01.2019 Patentblatt 2019/02**

(73) Patentinhaber: **Siemens Healthineers AG 91301 Forchheim (DE)**

(72) Erfinder: **Feiweier, Thorsten 91099 Poxdorf (DE)**

(74) Vertreter: **Siemens Healthineers Patent Attorneys Postfach 22 16 34 80506 München (DE)**

(56) Entgegenhaltungen:
**US-A- 5 786 692**

• **FREITAG ET AL.: "Reducing Short Term Gradient Heating by Usage of Adapted Encoding Schemes", PROCEEDINGS OF THE INTERNATIONAL SOCIETY FOR MAGNETIC RESONANCE IN MEDICINE, ISMRM, 19TH ANNUAL MEETING AND EXHIBITION, MONTREAL, QUEBEC, 7-13 MAY 2011, 23 April 2011 (2011-04-23), XP040620658**

**Beschreibung**

Die Erfindung betrifft ein Verfahren, ein Magnetresonanzgerät, ein Computerprogrammprodukt sowie einen elektronisch lesbaren Datenträger zu einer Optimierung einer zeitlichen Abfolge einer MR-Steuerungssequenz.

In einem Magnetresonanzgerät wird üblicherweise der zu untersuchende Körper eines Untersuchungsobjektes, insbesondere eines Patienten, mit Hilfe eines Hauptmagneten einem relativ hohen Hauptmagnetfeld, beispielsweise von 1,5 oder 3 oder 7 Tesla, ausgesetzt. Zusätzlich werden mit Hilfe einer Gradientenspuleneinheit Gradientenpulse ausgespielt. Über eine Hochfrequenzantenneneinheit werden dann mittels geeigneter Antenneneinrichtungen hochfrequente Hochfrequenz-Pulse, beispielsweise Anregungspulse, ausgesendet, was dazu führt, dass die Kernspins bestimmter, durch diese Hochfrequenz-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale, abgestrahlt, die mittels geeigneter Hochfrequenzantennen empfangen und dann weiterverarbeitet werden. Aus den so akquirierten Rohdaten können schließlich die gewünschten Bilddaten rekonstruiert werden. Insbesondere werden Rohdaten in einem räumlich begrenzten Ausschnitt des Untersuchungsobjektes, dem Untersuchungsbereich, aufgenommen. Die Bilddaten stellen den Untersuchungsbereich bildlich dar.

Für eine bestimmte Messung ist daher eine bestimmte Magnetresonanz-Steuerungssequenz (MR-Steuerungssequenz), auch Pulssequenz genannt, auszusenden, welche aus einer Folge von Hochfrequenz-Pulsen, beispielsweise Anregungspulsen und Refokussierungspulsen, sowie passend dazu koordiniert auszusendenden Gradientenpulsen in verschiedenen Gradientenachsen entlang verschiedener Raumrichtungen besteht. Zeitlich passend hierzu werden Auslesefenster gesetzt, welche die Zeiträume vorgeben, in denen die induzierten Magnetresonanz-Signale erfasst werden. Insbesondere das Aussenden der Hochfrequenz-Pulse und der Gradientenpulse erfordert eine Leistung, welche dem Magnetresonanzgerät zugeführt und durch das Magnetresonanzgerät in die entsprechenden Pulse umgewandelt wird. Dadurch wird zumindest ein Teil des Magnetresonanzgeräts thermisch belastet und das Magnetresonanzgerät kann sich zumindest teilweise erwärmen. Typischerweise ist eine Begrenzung der Erwärmung erforderlich. Die Erwärmung kann beispielsweise durch Kühlung limitiert werden. Dies wird beispielsweise in DE 10 2011 083 204 A1 und DE 10 2007 009 204 A1 vorgeschlagen. Zusätzlich werden MR-Steuerungssequenzen typischerweise derart ausgelegt, dass zwischen bestimmten Hochfrequenz-Pulsen und/oder Gradientenpulsen und/oder zum Ende der MR-Steuerungssequenz Pausen auftreten, welche Pausen frei von Hochfrequenz-Pulsen und/oder Gradientenpulsen sind. In diesen Pausen ist das Magnetresonanzgerät frei von einer zusätzlichen signifikanten thermischen Belastung.

Mit steigendem Kostendruck im Gesundheitswesen erhält die Forderung nach kurzen Zeitdauern von Magnetresonanzuntersuchungen eine stark zunehmende Bedeutung. Trotz der Einführung von Beschleunigungstechniken wie paralleler Bildgebung, "Compressed Sensing" oder simultaner Mehrschicht-Bildgebung liegen die Aufnahmezeiten vieler Messungen immer noch im Bereich mehrerer Minuten, so dass jeder Ansatz zu weiterer Messzeitreduktion - idealerweise in Kombination mit zuvor genannten Techniken - bedeutsam ist. In einigen Fällen bestimmen Limitierungen von Hardware-Komponenten, typischerweise Limitierungen der Leistungstechnik, die Grenzen für eine weitere Verkürzung der Aufnahmezeiten. Werden diese Grenzen nicht ausgenutzt oder zu konservativ abgeschätzt, dauern Messungen unnötig lange.

Gemäß dem Stand der Technik werden heuristische Referenzparameter festgelegt, durch die Hardware-Komponenten beschrieben werden. MR-Steuerungssequenzen werden entsprechend dieser Referenzparameter ausgelegt. Beispielsweise kann auf diese Weise die Limitierung der Gradientenspuleneinheit durch eine Referenz-Amplitude beschrieben werden: sofern Gradientenpulse eine Amplitude aufweisen, welche geringer als die Referenz-Amplitude ist, ist die Ausführbarkeit einer MR-Steuerungssequenz umfassend die Gradientenpulse typischerweise über die Untersuchungsdauer hinweg sichergestellt. Derartige Gradientenpulse und MR-Steuerungssequenzen sind typischerweise konservativ gewählt und nutzen die Limitierung der Gradientenspuleneinheit nur für wenige von der MR-Steuerungssequenz umfasste Gradientenpulse aus. Beispielsweise wird eine zumindest kurzfristige Ausführung von Gradientenpulsen mit Amplituden oberhalb der Referenz-Amplitude nicht betrachtet.

Modellbasierte Verfahren, wie beispielsweise in DE 10 2008 015 261 B4 beschrieben, nutzen die vorhandenen Hardware-Komponenten weitaus besser. Bei modellbasierten Verfahren wird die limitierende Hardware-Komponente durch ein Modell beschrieben, wodurch für einzelne Gradientenpulse und/oder einzelne Sequenz-Module Amplituden oberhalb der Referenz-Amplitude verwendet werden können. Zusätzlich können Pausen zur Einhaltung von Langzeit-Limitierungen automatisch bestimmt werden. So ist es beispielsweise möglich, kurzzeitig Gradientenpulse mit Amplituden oberhalb der Referenz-Amplitude zu verwenden, wenn danach ausreichend lange Pausen eingehalten werden.

US5786692A offenbart eine optimierte Anordnung von Sequenzabschnitten mit verschiedener Diffusionswichtung. Freitag et al., "Reducing Short Term Gradient Heating by Usage of Adapted Encoding Schemes", Proceedings of the ISMRM, 19th annual meeting, 7-13 Mai 2011, XP040620658, offenbart ein Optimierungsverfahren für Kodierungsschritte zur Reduzierung einer kurzzeitigen Erwärmung der Gradientenspulen.

Der Erfindung liegt die Aufgabe zugrunde, ein besonders effizientes Verfahren zu einer Optimierung einer zeitlichen Abfolge einer MR-Steuerungssequenz anzugeben. Die Aufgabe wird durch die Merkmale der unabhängigen Ansprüche gelöst. Vorteilhafte Ausgestaltungen sind in den Unteransprüchen beschrieben.

Das erfindungsgemäße Verfahren zu einer Optimierung einer zeitlichen Abfolge einer MR-Steuerungssequenz,

gemäß welcher MR-Steuerungssequenz ein Magnetresonanzgerät ansteuerbar ist,
wobei die MR-Steuerungssequenz zumindest zwei Sequenz-Module aufweist,
sieht die folgenden Verfahrensschritten vor:

- Erfassen einer Eigenschaft einer vom Magnetresonanzgerät umfassten Komponente umfassend eine Gradientenspuleneinheit umfassend zumindest zwei Gradientenspulen zur Erzeugung von Magnetfeldgradienten in zumindest zwei voneinander verschiedenen Richtungen,
- Ermittlung einer ersten Anforderung an die Komponente für ein erstes Sequenz-Modul der zumindest zwei Sequenz-Module,
- Ermittlung einer zweiten Anforderung an die Komponente für ein zweites Sequenz-Modul der zumindest zwei Sequenz-Module,
- Optimierung der zeitlichen Abfolge der zumindest zwei Sequenz-Module unter Berücksichtigung der Eigenschaft, der ersten Anforderung und der zweiten Anforderung, wobei die Eigenschaft der Komponente eine maximale Leistung für eine erste der zumindest zwei Gradientenspulen und eine maximale Leistung für eine zweite der zumindest zwei Gradientenspulen umfasst, die erste Anforderung eine erste Information bezüglich einer ersten Richtung der zumindest zwei voneinander verschiedenen Richtungen umfasst und die zweite Anforderung eine zweite Information bezüglich einer zweiten Richtung der zumindest zwei voneinander verschiedenen Richtungen umfasst, das erste Sequenz-Modul die erste Gradientenspule überdurchschnittlich stark beansprucht und das zweite Sequenz-Modul die zweite Gradientenspule überdurchschnittlich stark beansprucht, und bei der Optimierung der zeitlichen Abfolge die zumindest zwei voneinander verschiedenen Richtungen und die erste Information und die zweite Information berücksichtigt werden, wobei in einem weiteren Verfahrensschritt das Magnetresonanzgerät mittels der optimierten MR-Steuerungssequenz angesteuert wird.

Dem Verfahren wird typischerweise eine zu optimierende MR-Steuerungssequenz bereitgestellt, welche als originäre MR-Steuerungssequenz bezeichnet werden kann. Die zeitliche Abfolge von von einer MR-Steuerungssequenz umfassten Hochfrequenz-Pulsen und Gradientenpulsen und Auslesefenster ist für zu rekonstruierende Bilddaten signifikant. Die zeitliche Abfolge von von einer MR-Steuerungssequenz umfassten Sequenz-Modulen ist vorzugsweise variabel. Die originäre MR-Steuerungssequenz weist eine bereits vorgegebene, originäre Abfolge von zumindest zwei Sequenz-Modulen auf. Die originäre zeitliche Abfolge der zumindest zwei Sequenz-Module ist gemäß dem erfindungsgemäßen Verfahren zu optimieren.

Ein Sequenz-Modul ist typischerweise ein zeitlicher Abschnitt einer MR-Steuerungssequenz, welcher zumindest einen Hochfrequenz-Puls und/oder einen Gradientenpuls und/oder ein Auslesefenster umfasst. Eine zeitliche Abfolge der von einem Sequenz-Modul umfassten Hochfrequenz-Pulse und/oder Gradientenpulse und/oder Auslesefenster ist für die Erzeugung von Bilddaten eines bestimmten Kontrastes typischerweise fest vorgegeben. Ein Sequenz-Modul ist vorzugsweise ein in sich geschlossener Abschnitt einer MR-Steuerungssequenz, gemäß welchem Abschnitt eine definierte Menge von Rohdaten mit einem definierten Kontrast erzeugt und/oder aufgenommen wird.

Das erste Sequenz-Modul kann beispielsweise dazu ausgebildet sein, erste Rohdaten eines ersten Teilbereiches des Untersuchungsbereiches mit einem ersten Kontrast zu erzeugen und/oder zu akquirieren. Das zweite Sequenz-Modul kann beispielsweise dazu ausgebildet sein, zweite Rohdaten eines zweiten Teilbereiches des Untersuchungsbereiches mit einem zweiten Kontrast zu erzeugen und/oder zu akquirieren. Vorzugsweise ist zumindest der erste Teilbereich vom zweiten Teilbereich und/oder der erste Kontrast vom zweiten Kontrast verschieden. Ein bestimmter Kontrast kann erzeugt werden, indem ein Sequenz-Modul beispielsweise eine Diffusionswichtung in eine bestimmte Richtung und/oder mit einem bestimmten b-Wert umfasst. Ein bestimmter Kontrast kann erzeugt werden, indem ein Sequenz-Modul eine Unterdrückung eines Signals eines bestimmten Gewebes während einer vom Sequenz-Modul umfassten Aufnahme von Rohdaten bewirkt. Die mit allen von der MR-Steuerungssequenz umfassten Sequenz-Modulen aufgenommenen Rohdaten können zu Bilddaten rekonstruiert werden, welche den Untersuchungsbereich in einem Kontrast und/oder eine Funktion des Untersuchungsbereiches, wie beispielsweise eine Diffusionskarte, widergeben.

Der erste Teilbereich und/oder der zweite Teilbereich kann beispielsweise ein Teilbereich des Untersuchungsbereiches sein. Der erste Teilbereich und/oder der zweite Teilbereich kann beispielsweise ein Teilbereich des Rohdatenraumes, insbesondere des k-Raumes sein. So kann der erste Teilbereich beispielsweise dadurch gekennzeichnet sein, dass die von dem ersten Teilbereich umfassten Punkte des k-Raumes in zumindest einer Koordinate übereinstimmen. Die zumindest eine übereinstimmende Koordinate ist vorzugsweise durch einen Phasenkodierschritt bestimmt. Analog kann der zweite Teilbereich dadurch gekennzeichnet sein, dass die von dem zweiten Teilbereich umfassten Punkte des k-Raumes in zumindest einer Koordinate übereinstimmen. Die MR-Steuerungssequenz kann das erste Sequenz-Modul und/oder das zweite Sequenz-Modul mehrfach umfassen.

Die Komponente umfasst erfindungsgemäß eine Gradientenspuleneinheit umfassend zumindest zwei Gradientenspulen zur Erzeugung von Magnetfeldgradienten in zumindest zwei voneinander verschiedenen Richtungen und ist bei dem Ausspielen des ersten Sequenz-Moduls und/oder des zweiten Sequenz-Moduls einer Belastung ausgesetzt. Die Komponente umfasst typischerweise zumindest ein Bauteil und/oder zumindest eine abgeschlossene Funktionseinheit des Magnetresonanzgerätes. Die Komponente kann dazu ausgebildet sein, vom ersten Sequenz-Modul und/oder vom zweiten Sequenz-Modul umfasste Gradientenpulse und/oder Hochfrequenz-Pulse auszuspielen. Die Komponente ist typischerweise durch die Eigenschaft charakterisiert. Die Eigenschaft umfasst typischerweise eine Spezifikation, vorzugsweise eine technische Spezifikation, der Komponente. Erfindungsgemäß umfasst die Eigenschaft eine maximale Leistung für eine erste der zumindest zwei Gradientenspulen und eine maximale Leistung für eine zweite der zumindest zwei Gradientenspulen.

Dadurch charakterisiert die Eigenschaft die Komponente hinsichtlich der ersten Anforderung und der zweiten Anforderung.

Das Magnetresonanzgerät, insbesondere eine Steuereinheit und/oder eine Optimierungseinheit des Magnetresonanzgerätes, können dazu ausgebildet sein, die Eigenschaft, beispielsweise ein technisches Merkmal des Magnetresonanzgerätes und/oder der Komponente, zu ermitteln. Die Eigenschaft kann auf einer vom Magnetresonanzgerät umfassten Speichereinheit hinterlegt sein und/oder der Steuereinheit und/oder der Optimierungseinheit von einer Speichereinheit bereitgestellt werden.

Eine Anforderung an die Komponente für ein Sequenz-Modul ist typischerweise eine für das Ausspielen des Sequenz-Moduls und/oder eine für eine Ausführbarkeit der das Sequenz-Modul umfassenden MR-Steuerungssequenz erforderliche Ausbildung und/oder erforderliche Fähigkeit der Komponente. Die erste Anforderung hängt insbesondere von der Komponente und dem ersten Sequenz-Modul ab. Die zweite Anforderung hängt insbesondere von der Komponente und dem zweiten Sequenz-Modul ab.

Die erste Anforderung kann mittels der Steuereinheit und/oder der Optimierungseinheit bestimmt werden. Hierfür erfolgt vorzugsweise eine Analyse des ersten Sequenz-Moduls. Ist die Komponente beispielsweise ein Hochfrequenzverstärker, so können bei der Ermittlung der ersten Anforderung von dem ersten Sequenz-Modul umfasste Hochfrequenz-Pulse extrahiert und/oder hinsichtlich Dauer und/oder Amplitude analysiert werden. Basierend auf deren Anzahl, deren zeitlicher Abstand, der jeweiligen Dauer und/oder der jeweiligen Amplitude kann beispielsweise eine vom Hochfrequenzverstärker erforderliche Leistung für das erste Sequenz-Modul bestimmt werden. Diese erforderliche Leistung kann von der ersten Anforderung umfasst sein. Für die zweite Anforderung des zweiten Sequenz-Moduls kann analoges gelten. Bei der Ermittlung der ersten Anforderung und/oder der zweiten Anforderung kann die Steuereinheit und/oder die Optimierungseinheit optional auf eine Datenbank und/oder Speichereinheit zugreifen, auf welcher eine Information hinterlegt sein kann. Eine derartige Information kann beispielsweise einen Zusammenhang zwischen einem Hochfrequenz-Puls mit einer bestimmten Dauer und/oder einer bestimmten Amplitude und einer Anforderung an die Komponente umfassen. Erfindungsgemäß umfasst die erste Anforderung eine erste Information bezüglich einer ersten Richtung der zumindest zwei voneinander verschiedenen Richtungen und die zweite Anforderung eine zweite Information bezüglich einer zweiten Richtung der zumindest zwei voneinander verschiedenen Richtungen.

Die Optimierung der zeitlichen Abfolge zumindest des ersten Sequenz-Moduls und des zweiten Sequenz-Moduls erfolgt typischerweise basierend auf der Eigenschaft, der ersten Anforderung und der zweiten Anforderung. Die zeitliche Abfolge der zumindest zwei Sequenz-Module wird vorzugsweise derart von der MR-Steuerungssequenz adaptiert, dass die optimierte MR-Steuerungssequenz die optimierte zeitliche Abfolge der zumindest zwei Sequenz-Module aufweist. Sofern die optimierte zeitliche Abfolge von der originären zeitlichen Abfolge abweicht, unterscheidet sich die optimierte MR-Steuerungssequenz typischerweise von der originären MR-Steuerungssequenz. Die Optimierung der zeitlichen Abfolge der MR-Steuerungssequenz erfolgt vorzugsweise unter Berücksichtigung zumindest eines Teiles der von der MR-Steuerungssequenz umfassten Sequenz-Module, besonders bevorzugt unter Berücksichtigung aller von der MR-Steuerungssequenz umfassten Sequenz-Module. Hierbei wird vorzugsweise für jedes berücksichtigte Sequenz-Modul eine Anforderung an die Komponente ermittelt, welche bei der Optimierung der zeitlichen Abfolge der Sequenz-Module berücksichtigt wird. Bei der Optimierung der zeitlichen Abfolge der MR-Steuerungssequenz wird typischerweise die Reihenfolge von zumindest zwei Sequenz-Modulen geändert.

Der Vorteil des erfindungsgemäßen Verfahrens liegt darin, dass die Zeitdauer der Pausen zwischen Sequenz-Modulen verkürzt werden kann. Dadurch kann auch die gesamte Zeitdauer der MR-Steuerungssequenz reduziert werden. Das erfindungsgemäße Verfahren kann mit bekannten Beschleunigungstechniken wie paralleler Bildgebung, "Compressed Sensing" oder simultaner Mehrschicht-Bildgebung kombiniert werden.

Zusätzlich wird die Komponente vorzugsweise kontinuierlich belastet, wobei die Belastung der Komponente innerhalb der Spezifikation der Komponente erfolgt. Die Belastung der Komponente kann dabei mit weitgehend geringer Fluktuation erfolgen, wodurch die Komponente besonders schonend eingesetzt wird. Die Lebensdauer der Komponente kann dadurch verlängert werden. Zudem ermöglicht die Optimierung basierend auf der ersten Anforderung und der zweiten Anforderung eine für das erste Sequenz-Modul und das zweite Sequenz-Modul individuelle Anpassung der zeitlichen Abfolge der MR-Steuerungssequenz an das Magnetresonanzgerät, welches dazu ausgebildet ist, die MR-Steuerungssequenz zur Erzeugung von Rohdaten auszuspielen. Somit kann die Zeitdauer der MR-Steuerungssequenz hinsichtlich der von der MR-Steuerungssequenz umfassten Sequenz-Module, deren Anforderungen an die Komponente und das individuelle Magnetresonanzgerät optimiert werden. Eine mittels des erfindungsgemäßen Verfahrens optimierte MR-Steuerungssequenz ist typischerweise vom Magnetresonanzgerät ausführbar, da die Eigenschaft der Komponente berücksichtigt wurde. Insbesondere können neben der Komponente weitere Komponenten des Magnetresonanzgerätes bei der Ausführung des erfindungsgemäßen Verfahrens berücksichtigt werden.

Das erfindungsgemäße Verfahren erweitert den modellbasierten Ansatz um eine variable zeitliche Abfolge der Sequenz-Module. Die zeitliche Abfolge der Sequenz-Module ist beim erfindungsgemäßen Verfahren typischerweise veränderlich. Dabei kann die Eigenschaft, insbesondere eine Leistungsfähigkeit der Komponente berücksichtigt werden. Unter bestimmten Voraussetzungen kann derart die Zeitdauer der erforderlichen Pausen zwischen zwei aufeinanderfolgenden Sequenz-Modulen und/oder eine erforderliche Pause am Ende und/oder nach Abschluss der MR-Steuerungssequenz reduziert werden.

Eine Ausführungsform des Verfahrens sieht vor, dass die erste Anforderung eine für das erste Sequenz-Modul erforderliche Leistung der Komponente und/oder die zweite Anforderung eine für das zweite Sequenz-Modul erforderliche Leistung der Komponente umfasst. Die Komponente ist vorzugsweise für das Ausspielen des ersten Sequenz-Moduls und/oder des zweiten Sequenz-Moduls erforderlich. Die erste Anforderung ist demnach typischerweise ein Maß für die Belastung der Komponente beim Ausspielen des ersten Sequenz-Moduls. Die zweite Anforderung ist demnach typischerweise ein Maß für die Belastung der Komponente beim Ausspielen des zweiten Sequenz-Moduls. Die erste Anforderung kann auch eine im Rahmen des ersten Sequenz-Moduls an die Komponente abzugebende Leistung umfassen. Die zweite Anforderung kann auch eine im Rahmen des zweiten Sequenz-Moduls an die Komponente abzugebende Leistung umfassen. Gemäß dieser Ausführungsform kann die erste Anforderung und/oder die zweite Anforderung besonders genau bestimmt werden. Dadurch kann die Optimierung der MR-Steuerungssequenz besonders effizient erfolgen.

Die erfindungsgemäße Ausführungsform des Verfahrens sieht vor, dass die Eigenschaft eine Limitierung für die Komponente in Form einer maximalen Leistung für eine erste der zumindest zwei Gradientenspulen und einer maximalen Leistung für eine zweite der zumindest zwei Gradientenspulen angibt. Wird die Komponente innerhalb der Limitierung benutzt, so ist typischerweise eine sichere Benutzung und/oder Funktionalität und/oder definierte Präzision der Komponente gewährleistet. Insbesondere erfolgt beim Ausspielen der MR-Steuerungssequenz bei Einhaltung der Limitierung kein Abbruch der MR-Steuerungssequenz. Die Limitierung kann beispielsweise eine maximal zulässige Leistung umfassen, welche maximale zulässige Leistung der Komponente in einem bestimmten Zeitraum zugeführt werden kann. Die Limitierung kann beispielsweise eine maximal zulässige Leistung umfassen, welche maximale zulässige Leistung die Komponente in einem bestimmten Zeitraum abgeben kann. Die Eigenschaft kann auch ein Maß für eine Belastbarkeit der Komponente angeben. Vorzugsweise umfasst die Eigenschaft eine maximal zulässige Leistung und eine entsprechende Zeitdauer, während welcher Zeitdauer die Komponente mit der maximal zulässigen Leistung belastbar ist. Die Eigenschaft kann auch verschiedene maximal zulässige Leistungen für verschieden lange Zeitdauern umfassen. Diese Ausführungsform des Verfahrens ermöglicht eine besonders gute Ausnutzung der technischen Spezifikation der Komponente. Dadurch kann bei der Optimierung der MR-Steuerungssequenz eine besonders große Verkürzung der Zeitdauer erzielt werden.

Eine Ausführungsform des Verfahrens sieht vor, dass die zeitliche Abfolge derart optimiert wird, dass die erste Anforderung und die zweite Anforderung in einem zeitlichen Mittel die Eigenschaft der Komponente einhält. Vorzugsweise wird der zeitliche Ablauf des ersten Sequenz-Moduls und des zweiten Sequenz-Moduls derart gewählt, dass deren Ansprüche an die Komponente in dem zeitlichen Mittel die maximal zulässige Belastung der Komponente nicht überschreiten. Die Eigenschaft der Komponente ist vorzugsweise an eine Zeitdauer geknüpft, während welcher Zeitdauer die Eigenschaft einzuhalten gilt. Diese Ausführungsform ermöglicht demnach eine balancierte Belastung der Komponente über die Zeitdauer, welche eine für die Komponente charakteristische Zeitdauer und/oder eine an die Eigenschaft der Komponente geknüpfte Zeitdauer ist. Im Vergleich zur aus dem Stand der Technik bekannten Modellbeschreibung der Komponente und einer zeitlich gemittelten Betrachtung der Belastung können gemäß dieser Ausführungsform erforderliche Pausen in der MR-Steuerungssequenz reduziert werden. Dies kann die Untersuchungsdauer des Patienten reduzieren.

Eine Ausführungsform des Verfahrens sieht vor, dass die zeitliche Abfolge derart optimiert wird, dass eine Zeitdauer eines Teiles der MR-Steuerungssequenz umfassend das erste Sequenz-Modul und das zweite Sequenz-Modul und/oder eine gesamte Zeitdauer der MR-Steuerungssequenz minimiert wird. Die zeitliche Abfolge wird vorzugsweise derart optimiert, dass eine gesamte Zeitdauer der MR-Steuerungssequenz im Vergleich zur Zeitdauer der originären MR-Steuerungssequenz reduziert wird. Dadurch kann die Dauer der Untersuchung des Patienten reduziert werden. Dies ermöglicht kostengünstigere Untersuchungen und/oder eine bessere zeitliche Auslastung des Magnetresonanzgerätes.

Eine Ausführungsform des Verfahrens sieht vor, dass die zeitliche Abfolge derart optimiert wird, dass eine Belastung der Komponente aufgrund der ersten Anforderung und aufgrund der zweiten Anforderung in einem zeitlichen Mittel konstant ist. Die Belastung der Komponente aufgrund der ersten Anforderung und aufgrund der zweiten Anforderung ist in einem zeitlichen Mittel vorzugsweise zumindest weitgehend konstant. Das zeitliche Mittel kann sich beispielsweise auf einen Zeitraum umfassend das erste Sequenz-Modul und das zweite Sequenz-Modul beziehen. Die MR-Steuerungssequenz umfasst typischerweise zahlreiche Sequenz-Module. Die zeitliche Abfolge, also die Reihenfolge der zahlreichen Sequenz-Module wird vorzugsweise derart gewählt, dass eine Belastung der Komponente gemittelt über einen Zeitraum umfassend wenige aufeinanderfolgende der zahlreichen Sequenz-Module während dem Ausspielen der MR-Steuerungssequenz weitgehend konstant ist, also eine Abweichung von weniger als 30%, vorzugsweise von weniger als 15% von der Belastung der Komponente gemittelt über einen Zeitraum umfassend die zahlreichen Sequenz-Module beträgt. Diese Ausführungsform des Verfahrens ermöglicht eine balancierte Ansteuerung der Komponente bei einer zeitgemittelten Betrachtung der Belastung zur Reduktion der Dauer der MR-Steuerungssequenz durch eine optimierte Ausnutzung der verfügbaren Spezifikation der Komponente.

Das erfindungsgemäße Verfahren und/oder besonders vorteilhaft diese Ausführungsform kann auch für Sequenz-Module verwendet werden, welche Sequenz-Module dazu ausgebildet sind, Rohdaten eines Teilbereiches des Untersuchungsbereiches und/oder des Untersuchungsbereiches mit einer definierten Phasenkodierung zu erzeugen und/oder zu akquirieren. Ein derartiges Sequenz-Modul umfasst demnach vorzugsweise das Erzeugen und/oder die Akquisition der Rohdaten mit nur einem Phasenkodierschritt. Ein weiteres derartiges Sequenz-Modul umfasst demnach vorzugsweise das Erzeugen und/oder die Akquisition der Rohdaten mit nur einem weiteren Phasenkodierschritt. Die originäre MR-Steuerungssequenz umfasst vorzugsweise mehrere Sequenz-Module umfassend das erste Sequenz-Modul und das zweite Sequenz-Modul. Die mehreren Sequenz-Module unterscheiden sich typischerweise in ihren Phasenkodierschritten voneinander. Typischerweise werden derartige Sequenz-Module gemäß dem Stand der Technik in originärer zeitlicher Abfolge mit auf- oder absteigender Amplitude des den jeweiligen Phasenkodierschritt erzeugenden Gradientenpulses angeordnet. Dadurch weisen direkt aufeinanderfolgende Sequenz-Module in einem ersten Abschnitt der originären MR-Steuerungssequenz überdurchschnittliche Amplituden der Gradientenpulse zur Phasenkodierung auf und in einem zweiten Abschnitt der originären MR-Steuerungssequenz unterdurchschnittliche Amplituden der Gradientenpulse zur Phasenkodierung auf. Je größer die Amplitude der Gradientenpulse ist, desto höher ist typischerweise die Belastung der Komponente. Würde eine derartige originäre MR-Steuerungssequenz gemäß dieser Ausführungsform des Verfahrens optimiert werden, so könnte die optimierte zeitliche Abfolge der mehreren Sequenz-Module beispielsweise abwechselnd überdurchschnittliche und unterdurchschnittliche Amplituden der Gradientenpulse zur Phasenkodierung verwenden. Dadurch kann die Belastung der Komponente während des Ausspielens der MR-Steuerungssequenz gemittelt über einen Zeitraum umfassend zwei aufeinanderfolgende Sequenz-Module balanciert, also weitgehend konstant, vorzugsweise mit geringer Fluktuation gestaltet werden. Das erfindungsgemäße Verfahren und/oder insbesondere diese Ausführungsform ermöglichen eine thermisch balancierte Ansteuerung der Komponente bei einer zeitgemittelten Betrachtung der thermischen Belastung zur Messzeitreduktion durch eine optimierte Ausnutzung der verfügbaren Leistungsfähigkeit.

Eine Ausführungsform des Verfahrens sieht vor, dass die Optimierung der zeitlichen Abfolge eine Wahl einer Pause umfasst. Die Pause bezieht sich vorzugsweise auf eine Zeitdauer zwischen dem ersten Sequenz-Modul und dem zweiten Sequenz-Modul. Demnach kann aktiv eine Zeitdauer in die MR-Steuerungssequenz eingefügt werden, welche Zeitdauer beim Ausspielen der MR-Steuerungssequenz frei von einem Hochfrequenz-Puls und/oder einem Gradientenpuls und/oder einem Auslesefenster ist. Hierdurch kann der zeitliche Verlauf der Belastung der Komponente beim Ausspielen der MR-Steuerungssequenz besonders balanciert bestimmt werden.

Eine Ausführungsform des Verfahrens sieht vor, dass die Komponente zumindest eines der folgenden Bauteile umfasst:

- Gradientenverstärker,
- Gradientenkabel,
- Hochfrequenzverstärker,
- Hochfrequenzantenneneinheit,
- Hochfrequenzkabel,
- Filterplatte.

Ein Gradientenkabel kann einen Gradientenverstärker mit einer Gradientenspule verbinden. Ein Hochfrequenzkabel kann einen Hochfrequenzverstärker mit einer Hochfrequenzantenneneinheit verbinden. Ein Gradientenverstärker ist typischerweise dazu ausgebildet, eine Spannung und/oder eine Leistung derart aufzubereiten und die Gradientenspuleneinheit mit der aufbereiteten Spannung und/oder Leistung derart zu versorgen, dass Gradientenpulse gemäß der MR-Steuerungssequenz erzeugt werden. Ein Hochfrequenzverstärker ist typischerweise dazu ausgebildet, eine Spannung derart aufzubereiten und die Hochfrequenzantenneneinheit mit der aufbereiteten Spannung derart zu versorgen, dass Hochfrequenz-Pulse gemäß der MR-Steuerungssequenz erzeugt werden. Die genannten Bauteile sind typischerweise beim Ausspielen der MR-Steuerungssequenz einer hohen Belastung, beispielsweise durch hohe elektrische Spannung und/oder damit verbundener Wärme, ausgesetzt. Demnach ist eine Überwachung eines solchen Bauteils durch Berücksichtigung dieses Bauteils als Komponente gemäß dem erfindungsgemäßen Verfahren besonders vorteilhaft.

Eine Ausführungsform des Verfahrens sieht vor, dass die Komponente durch eine Zeitkonstante beschrieben wird, welche Zeitkonstante größer als eine Zeitdauer des ersten Sequenz-Moduls und/oder des zweiten Sequenz-Moduls ist. Die Komponente weist demnach eine Zeitkonstante auf und/oder die Komponente, insbesondere die Eigenschaft der Komponente, wird durch die Zeitkonstante charakterisiert. Die Zeitkonstante bezieht sich vorzugsweise auf eine Temperatur der Komponente. Insbesondere sind Zeitkonstanten interessant, die länger als die Zeitdauer eines Sequenz-Moduls sind. Die Zeitdauer eines Sequenz-Moduls beträgt typischerweise zwischen zehn Millisekunden und mehreren hundert Millisekunden.

Demnach werden vorzugsweise Komponenten mit einer Zeitkonstante von zumindest hundert Millisekunden, besonders bevorzugt von zumindest zehn Millisekunden bei dem erfindungsgemäßen Verfahren berücksichtigt. Derartige Komponenten weisen nach einer thermischen Belastung durch das erste Sequenz-Modul auch bei folgenden Sequenz-Modulen typischerweise noch eine signifikante Erwärmung aufgrund des ersten Sequenz-Moduls auf, weshalb eine optimierte zeitliche Anordnung der von der MR-Steuerungssequenz umfassten Sequenz-Module besonders vorteilhaft ist. Insbesondere Gradientenspuleneinheiten und Transformatoren können thermischen Zeitkonstanten von einigen Minuten aufweisen.

Eine Ausführungsform des Verfahrens sieht vor, dass das erste Sequenz-Modul zu einer ersten Diffusionswichtung und das zweite Sequenz-Modul zu einer zweiten Diffusionswichtung ausgebildet sind. Eine derartige MR-Steuerungssequenz kann demnach zur Diffusions-Bildgebung verwendet werden. Bei der Diffusions-Bildgebung werden in der Regel mehrere diffusionskodierte Bilddaten mit unterschiedlichen Diffusionswichtungen, d. h. mit unterschiedlichen Diffusionsgradienten, aufgenommen und miteinander kombiniert. Die Stärke der Diffusionswichtung wird meist durch den sogenannten Diffusionsgewichtungsfaktor, auch als "b-Wert" bezeichnet, definiert. Zusätzlich kann eine Diffusionswichtung durch eine Richtung, insbesondere eine Raumrichtung, charakterisiert werden, in welche Richtung die Diffusionswichtung wirkt. Die unterschiedlichen diffusionskodierten Bilddaten bzw. die daraus zu kombinierenden diffusionsgewichteten Bilddaten können dann zu den gewünschten diagnostischen Zwecken verwendet werden. Das erste Sequenz-Modul und das zweite Sequenz-Modul erzeugen demnach vorzugsweise voneinander verschiedene Diffusionswichtungen, die sich im b-Wert und/oder in der Richtung unterscheiden. Typischerweise werden in der Diffusions-Bildgebung eine Vielzahl von Sequenz-Modulen mit zumindest teilweise unterschiedlichen Diffusionswichtungen verwendet.

Dies wird im Folgenden anhand eines Beispiels betrachtet. Eine MR-Steuerungssequenz umfasst beispielsweise zumindest 30 Sequenz-Module, wovon drei Sequenz-Module einen b-Wert von 0 ohne Richtungscharakteristik, vier Sequenz-Module einen b-Wert von 500s/mm^2 in jeweils drei Richtungen und fünf Sequenz-Module einem b-Wert von 1000s/mm^2 in jeweils drei Richtungen aufweisen. Gemäß dem Stand der Technik bestimmt der maximale b-Wert, also 1000s/mm^2, die thermische Belastung GT (1000) und damit die notwendige Messpause Tb'.

Mit der gemäß dieser Ausführungsform des erfindungsgemäßen Verfahrens optimierten zeitlichen Abfolge der 30 Sequenz-Module unter Berücksichtigung der thermische Belastung der Komponente im zeitlichen Mittel kann eine reduzierte thermische Belastung GTb angenommen werden: GTb $\propto$ 3/30 GT(0) + 12/30 GT(500) + 15/30 GT(1000) $\approx$ 0,7 GT(1000). Hierfür wurde ein linearer Zusammenhang zwischen der thermischen Belastung der Komponente und dem b-Wert angenommen. Bezeichnet Ta die Aufnahmezeit, welche zum Ausspielen der 30 Sequenz-Module erforderlich ist, und Tb die notwendige Messpause für die reduzierte thermische Belastung GTb, so gilt: Ta * GT(1000) / (Ta + Tb') = Ta * GTb / (Ta + Tb) $\approx$ 0,7 Ta * GT(1000) / (Ta + Tb) und damit Tb $\approx$ 0.7 Tb' - 0.3 Ta.

Bei Berücksichtigung der Grundlast der Komponente fällt die Reduktion der Pausendauer geringer als angegeben aus. Für die Erreichung der Reduktion der Pausendauer ist typischerweise eine entsprechend optimierte zeitliche Abfolge der Sequenz-Module erforderlich. Hierfür wird vorzugsweise eine gleichmäßige thermische Belastung der Komponente angestrebt.

Für eine entsprechende Optimierung der zeitlichen Abfolge von $\sum_{n=1}^{N} R_n W_n$ Sequenz-Modulen mit N b-Werten mit jeweils $R_n$ Richtungen und $W_n$ Wiederholungen kann beispielsweise wie folgt vorgegangen werden:

    1. Bestimmung desjenigen b-Wertes $b_i$, für den $A_{max} = R_i * W_i$ maximal ist (i ∈ 1, ...N).
    2. Aufnahme aller für den b-Wert $b_i$ aufzunehmenden Kombinationen aus Richtung und Wiederholung in einer Liste L. Die Liste L ist vor Aufnahme dieser Kombinationen vorzugsweise leer.

3. Bestimmung von $A_j = R_j * W_j$ ($j \in 1, ... N$) für einen nächsten b-Wert $b_j$, wessen aufzunehmende Kombinationen aus Richtung und Wiederholung in die Liste L bislang nicht aufgenommen wurden.

4. Bestimmung einer relativen Häufigkeit $H_j = E / A_j$, wobei E eine aktuelle Anzahl von Einträgen, also aufgenommenen b-Werten, in der Liste L ist. Gemäß Definition von $A_{max}$ ist $H_j \geq 1$ sichergestellt. Die relative Häufigkeit $H_j$ gibt an, wie viele Einträge der Liste L auf den b-Wert $b_j$ entfallen. Die relative Häufigkeit $H_j$ ist in der Regel nicht ganzzahlig.

5. Setzung eines Listen-Index auf einen ersten Eintrag der Liste L und Nullierung eines Zähler Z.

6. Wahl einer noch nicht in der Liste L aufgenommenen Kombination aus Richtung und Wiederholung für den b-Wert $b_j$.

7. Wiederholte Inkrementierung des Listen-Index und des Zählers bis zum kleinsten $Z \geq H$ ist.

8. Einfügen der gewählten Kombination aus Richtung und Wiederholung für den b-Wert $b_j$ am aktuellen Listen-Index in die Liste L.

9. Erniedrigung von Z um H. Z kann negativ sein. Z kann auch nicht ganzzahlig sein.

10. Weiter bei Schritt 6, solange für den b-Wert $b_j$ noch nicht alle Kombinationen aus Richtung und Wiederholung in die Liste L eingefügt wurden.

11. Weiter bei Schritt 3, solange noch nicht alle b-Werte $b_j$ mit $j \in 1, ... N$ betrachtet wurden.

Wird dieses Verfahren auf obiges Beispiel mit 30 Sequenz-Modulen angewendet, so ergibt sich die folgende zeitliche Abfolge der 30 Sequenz-Module: b500(1,1), b0(1,1), b1000(1,1), b500(1,2), b1000(1,2), b500(1,3), b1000(1,3), b1000(2,1), b500(2,1), b1000(2,2), b500(2,2), b0(2,1), b1000(2,3), b500(2,3), b1000(3,1), b500(3,1), b1000(3,2), b1000(3,3), b500(3,2), b1000(4,1), b500(3,3), b0(3,1), b1000(4,2), b500(4,1), b1000(4,3), 500(4,2), b1000(5,1), b1000(5,2), b500(4,3), b1000(5,3). Der erste Wert in den Klammern gibt hierbei die Nummer der Wiederholung und der zweite Wert die Richtung, nummeriert mit 1, 2, 3, an.

Gemäß dieser optimierten zeitlichen Abfolge der Sequenz-Module weisen maximal zwei aufeinanderfolgende Sequenz-Module einen b-Wert von 1000s/mm^2 auf. Zuvor und danach ist ein Sequenz-Modul mit kleinerem b-Wert vorgesehen. Die Pausen können somit entsprechend obiger Berechnung verkürzt werden. Die originäre MR-Steuerungssequenz weist hingegen typischerweise eine zeitliche Abfolge auf, gemäß welcher zumindest die Sequenz-Module mit einem b-Wert von 1000s/mm^2 der vierten und fünften Wiederholung in jeweils 3 Richtungen direkt aufeinanderfolgend gemessen werden. Somit ist beim Ausspielen dieser sechs Sequenz-Module die thermische Belastung der Komponente besonders hoch, wodurch typischerweise entsprechend lange Pausen zur Einhaltung der Limitierung der Komponente erforderlich sind. Simulationen zeigen, dass gemäß dem erfindungsgemäßen Verfahren die Dauer einer Kopfbildgebung mittels Diffusions- oder Tensor-Bildgebung und die Dauer der abdominellen Bildgebung um zumindest 10% bis 20% reduziert werden kann. Dabei können alle Leistungskomponenten im Rahmen ihrer Spezifikationen betrieben werden.

Erfindungsgemäß ist vorgesehen, dass die Komponente eine Gradientenspuleneinheit umfassend zumindest zwei Gradientenspulen zur Erzeugung von Magnetfeldgradienten in zumindest zwei voneinander verschiedenen Richtungen umfasst, die Eigenschaft der Komponente eine maximale Leistung für eine erste der zumindest zwei Gradientenspulen und eine maximale Leistung für eine zweite der zumindest zwei Gradientenspulen umfasst, die erste Anforderung eine erste Information bezüglich einer ersten Richtung der zumindest zwei voneinander verschiedenen Richtungen umfasst und/oder die zweite Anforderung eine zweite Information bezüglich einer zweiten Richtung der zumindest zwei voneinander verschiedenen Richtungen umfasst, und bei der Optimierung der zeitlichen Abfolge die zumindest zwei voneinander verschiedenen Richtungen und die erste Information und/oder die zweite Information berücksichtigt werden.

Dies ist besonders vorteilhaft, wenn das erste Sequenz-Modul überdurchschnittlich stark die erste Gradientenspule beansprucht, insbesondere viele Gradientenpulse und/oder Gradientenpulse mit hoher Amplitude in die erste Richtung vorsieht. Diese Ausführungsform ist besonders vorteilhaft, wenn das zweite Sequenz-Modul überdurchschnittlich stark die zweite Gradientenspule beansprucht, insbesondere viele Gradientenpulse und/oder Gradientenpulse mit hoher Amplitude in die zweite Richtung vorsieht. Die erste Richtung und die zweite Richtung entsprechen vorzugsweise je einer physikalischen Achse des Magnetresonanzgerätes. Gemäß dieser Ausführungsform kann die zeitliche Abfolge der Sequenz-Module derart angepasst

werden, dass die einzelnen Gradientenspulen der Gradientenspuleneinheit möglichst gleichmäßig belastet werden.

Im Folgenden wird ein Beispiel für diese Ausführungsform anhand einer Menge M umfassend zumindest drei Sequenz-Module erläutert. Die Gradientenspuleneinheit umfasst beispielhaft drei Gradientenspulen zur Erzeugung von Magnetfeldgradienten in drei voneinander verschiedenen Richtungen. Die Optimierung der zeitlichen Abfolge kann beispielsweise gemäß den folgenden Verfahrensschritten erfolgen:

1. Übertragung eines ersten Sequenz-Moduls der Menge M in eine Abfolge-Liste AL. Das übertragene erste Sequenz-Modul weist eine überdurchschnittlich hohe Anforderung an die erste Richtung auf. Insbesondere sieht das übertragene erste Sequenz-Modul eine Erzeugung von Magnetfeldgradienten überwiegend in eine erste Richtung vor.

2. Selektion eines zweiten Sequenz-Moduls der verbleibenden Menge M, wobei das zweite Sequenz-Modul der verbleibenden Menge M eine überdurchschnittlich hohe Anforderung an eine zweite Richtung aufweist. Insbesondere ist das zweite Sequenz-Modul der verbleibenden Menge M durch eine Erzeugung von Magnetfeldgradienten überwiegend in eine zweite Richtung gekennzeichnet. Die zweite Richtung ist vorzugsweise dadurch gekennzeichnet, dass sie weitgehend orthogonal zu der ersten Richtung ist. Hierbei kann als Maß für die Orthogonalität der Betrag des Vektorprodukts der ersten Richtung und der zweiten Richtung verwendet werden: je kleiner, desto orthogonaler.

3. Übertragung des selektierten zweiten Sequenz-Moduls von der Menge M in die Abfolge-Liste AL.

4. Selektion eines dritten Sequenz-Moduls der verbleibenden Menge M, wobei das dritte Sequenz-Modul der verbleibenden Menge M eine überdurchschnittlich hohe Anforderung an eine weitere Richtung aufweist. Insbesondere ist das dritte Sequenz-Modul der verbleibenden Menge M durch eine Erzeugung von Magnetfeldgradienten überwiegend in eine weitere Richtung gekennzeichnet. Die weitere Richtung ist vorzugsweise dadurch gekennzeichnet, dass sie weitgehend orthogonal zu den Richtungen der beiden zuletzt selektierten Sequenz-Modulen ist. Hierbei kann als Maß für die Orthogonalität der Betrag des Vektorproduktes der weiteren Richtung und dem Kreuzprodukt der Richtungen der beiden zuletzt selektierten Sequenz-Modulen verwendet werden.

5. Übertragung des selektierten dritten Sequenz-Moduls von der Menge M in die Abfolge-Liste AL.

6. Weiter bei Schritt 4, solange die Menge M noch nicht leer ist.

Die erste Richtung, die zweite Richtung und/oder die weitere Richtung können den drei voneinander verschiedenen Richtungen der Gradientenspuleneinheit entsprechen. Die erste Richtung, die zweite Richtung und/oder die weitere Richtung können unabhängig von den drei voneinander verschiedenen Richtungen der Gradientenspuleneinheit sein. Die erste Richtung, die zweite Richtung und/oder die weitere Richtung spannen vorzugsweise den gleichen Raum wie die drei voneinander verschiedenen Richtungen der Gradientenspuleneinheit auf.

Gemäß dieser Ausführungsform wird demnach die Belastung der Gradientenspuleneinheit aufgrund eines Sequenz-Moduls hinsichtlich der räumlichen Richtung des Gradientenpulses und der betroffenen Gradientenspule berücksichtigt. Dadurch kann die Optimierung der MR-Steuerungssequenz besonders genau und effizient erfolgen. Die Dauer der MR-Steuerungssequenz kann dadurch besonders stark verkürzt werden. Insbesondere in der Diffusions-Tensor-Bildgebung sind Sequenz-Module mit Diffusionswichtungen in mehrere verschiedene Richtungen vorgesehen, wodurch diese Ausführungsform des erfindungsgemäßen Verfahrens für MR-Steuerungssequenzen der Diffusions-Tensor-Bildgebung besonders effektiv ist.

Eine Ausführungsform des Verfahrens sieht vor, dass in einem weiteren Verfahrensschritt das Magnetresonanzgerät mittels der optimierten MR-Steuerungssequenz angesteuert wird. Dieser Verfahrensschritt sieht demnach typischerweise das Ausspielen der optimierten MR-Steuerungssequenz unter Benutzung des Magnetresonanzgeräts vor. Dadurch kann die optimierte MR-Steuerungssequenz ihre Wirkung entfalten. Beispielsweise kann dadurch tatsächlich eine Untersuchungsdauer verkürzt werden.

Eine Ausführungsform des Verfahrens sieht vor, dass das Verfahren eine Selektion der zumindest zwei Sequenz-Module aus einer Vielzahl von Sequenz-Modulen umfasst. Die MR-Steuerungssequenz umfasst typischerweise eine Vielzahl von Sequenz-Modulen, also mehr als die zumindest zwei Sequenz-Module. Bei bestimmten MR-Steuerungssequenzen kann auf einzelne und/oder bestimmte von ihr umfasste Sequenz-Module verzichtet werden. Bei einem Verzicht werden typischerweise weniger Rohdaten erzeugt und/oder akquiriert, wobei die fehlenden Rohdaten beispielsweise mittels Interpolation oder durch Reduktion einer Auflösung der zu erzeugenden Bilddaten kompensiert werden können. Bei einer derartigen MR-Steuerungssequenz kann beispielsweise nach dem Erfassen der Eigenschaft der Komponente eine Selektion der zumindest zwei Sequenz-Module aus der Vielzahl der Sequenz-Module erfolgen. Bei der Selektion der zumindest zwei Sequenz-Module aus der Vielzahl der Sequenz-Module wird vorzugsweise die Eigenschaft der Komponente berücksichtigt. Insbesondere bei die Komponente stark belastenden MR-Steuerungssequenzen und/oder Sequenz-Modulen kann ein derartiges Verfahren eine kurze Aufnahmedauer ermöglichen.

Des Weiteren geht die Erfindung aus von einem Magnetresonanzgerät mit einer Komponente und einer Steuerungseinheit umfassend eine Optimierungseinheit. Die Optimierungseinheit ist dazu ausgebildet, ein erfindungsgemäßes Verfahren zu einer Optimierung einer zeitlichen Abfolge einer MR-Steuerungssequenz auszuführen. Dafür weist die Optimierungseinheit typischerweise einen Eingang, eine Prozessoreinheit und einen Ausgang auf. Über den Eingang können der Optimierungseinheit eine zu optimierende MR-Steuerungssequenz und/oder eine Eigenschaft einer vom Magnetresonanzgerät umfassten Komponente bereitgestellt werden. Weitere, im Verfahren benötigte Funktionen, Algorithmen oder Parameter können der Optimierungseinheit über den Eingang bereitgestellt werden. Die optimierte zeitliche Abfolge der MR-Steuerungssequenz und/oder weitere Ergebnisse einer Ausführungsform des erfindungsgemäßen Verfahrens können über den Ausgang bereitgestellt werden. Die optimierte zeitliche Abfolge der MR-Steuerungssequenz kann an die Steuerungseinheit übermittelt werden, wodurch das Magnetresonanzgerät gemäß einer optimierten MR-Steuerungssequenz umfassend die optimierte zeitliche Abfolge der MR-Steuerungssequenz ansteuerbar ist. Die Optimierungseinheit kann in das Magnetresonanzgerät integriert sein. Die Optimierungseinheit kann auch separat von dem Magnetresonanzgerät installiert sein. Die Optimierungseinheit kann mit dem Magnetresonanzgerät verbunden sein.

Ausführungsformen des erfindungsgemäßen Magnetresonanzgerätes sind analog zu den Ausführungsformen des erfindungsgemäßen Verfahrens ausgebildet. Das Magnetresonanzgerät kann weitere Steuerungskomponenten aufweisen, welche zum Ausführen eines erfindungsgemäßen Verfahrens nötig und/oder vorteilhaft sind. Auch kann das Magnetresonanzgerät dazu ausgebildet sein, Steuerungssignale zu senden und/oder Steuerungssignale zu empfangen und/oder zu verarbeiten, um ein erfindungsgemäßes Verfahren auszuführen. Vorzugsweise ist die Optimierungseinheit Teil der Steuerungseinheit des erfindungsgemäßen Magnetresonanzgeräts. Auf einer Speichereinheit der Optimierungseinheit können Computerprogramme und weitere Software gespeichert sein, mittels derer die Prozessoreinheit der Optimierungseinheit einen Verfahrensablauf eines erfindungsgemäßen Verfahrens automatisch steuert und/oder ausführt.

Ein erfindungsgemäßes Computerprogrammprodukt ist direkt in einer Speichereinheit einer programmierbaren Optimierungseinheit ladbar und weist Programmcode-Mittel auf, um ein erfindungsgemäßes Verfahren auszuführen, wenn das Computerprogrammprodukt in der Optimierungseinheit ausgeführt wird. Dadurch kann das erfindungsgemäße Verfahren schnell, identisch wiederholbar und robust ausgeführt werden. Das Computerprogrammprodukt ist so konfiguriert, dass es mittels der Optimierungseinheit die erfindungsgemäßen Verfahrensschritte ausführen kann. Die Optimierungseinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können. Das Computerprogrammprodukt ist beispielsweise auf einem elektronisch lesbaren Medium gespeichert oder auf einem Netzwerk oder Server hinterlegt, von wo es in den Prozessor einer lokalen Optimierungseinheit geladen werden kann, der mit dem Magnetresonanzgerät direkt verbunden oder als Teil des Magnetresonanzgeräts ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Optimierungseinheit eines Magnetresonanzgeräts ein erfindungsgemäßes Verfahren durchführen. Beispiele für elektronisch lesbare Datenträger sind eine DVD, ein Magnetband oder einen USB-Stick, auf welchem elektronisch lesbare Steuerinformationen, insbesondere Software, gespeichert ist. Wenn diese Steuerinformationen (Software) von dem Datenträger gelesen und in eine Steuerungseinheit und/oder Optimierungseinheit eines Magnetresonanzgeräts gespeichert werden, können alle erfindungsgemäßen Ausführungsformen der vorab beschriebenen Verfahren durchgeführt werden.

Des Weiteren geht die Erfindung aus von einem elektronisch lesbaren Datenträger, auf dem ein Programm hinterlegt ist, das zu einer Ausführung eines Verfahrens zu einer Optimierung einer zeitlichen Abfolge einer MR-Steuerungssequenz, vorgesehen ist.

Die Vorteile des erfindungsgemäßen Magnetresonanzgeräts, des erfindungsgemäßen Computerprogrammprodukts und des erfindungsgemäßen elektronisch lesbaren Datenträgers entsprechen im Wesentlichen den Vorteilen des erfindungsgemäßen Verfahrens zu einer Optimierung einer zeitlichen Abfolge einer MR-Steuerungssequenz, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Weitere Vorteile, Merkmale und Einzelheiten der Erfindung ergeben sich aus den im Folgenden beschriebenen Ausführungsbeispielen sowie anhand der Zeichnungen.

Es zeigen:

Fig. 1　　ein erfindungsgemäßes Magnetresonanzgerät in einer schematischen Darstellung,

Fig. 2　　ein Ablaufdiagramm einer Ausführungsform eines erfindungsgemäßen Verfahrens,

Fig. 3　　eine schematische Darstellung einer aus dem Stand der Technik bekannten zeitlichen Abfolge einer MR-Steuerungssequenz, und

Fig. 4　　eine schematische Darstellung einer optimierten zeitlichen Abfolge einer MR-Steuerungssequenz.

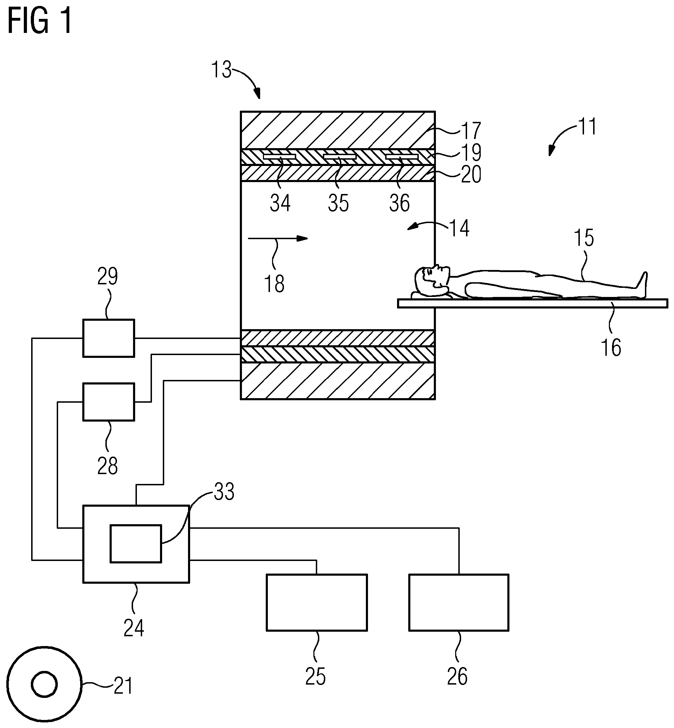

Figur 1 zeigt ein Magnetresonanzgerät 11 zur Ausführung eines erfindungsgemäßen Verfahrens in einer schematischen Darstellung. Das Magnetresonanzgerät 11 umfasst eine von einer Magneteinheit 13 gebildeten Detektoreinheit mit einem Hauptmagneten 17 zu einem Erzeugen eines starken und insbesondere konstanten Hauptmagnetfelds 18. Zudem weist das Magnetresonanzgerät 11 einen zylinderförmigen Patientenaufnahmebereich 14 zu einer Aufnahme eines Patienten 15 auf, wobei der Patientenaufnahmebereich 14 in einer Umfangsrichtung von der Magneteinheit 13 zylinderförmig umschlossen ist. Der Patient 15 kann mittels einer Patientenlagerungsvorrichtung 16 des Magnetresonanzgeräts 11 in den Patientenaufnahmebereich 14 geschoben werden. Die Patientenlagerungsvorrichtung 16 weist hierzu einen Patiententisch auf, der bewegbar innerhalb des Magnetresonanzgeräts 11 angeordnet ist.

Die Magneteinheit 13 weist weiterhin eine Gradientenspuleneinheit 19 auf, die für eine Ortskodierung während einer Bildgebung verwendet werden. Die dargestellte Gradientenspuleneinheit 19 umfasst drei Gradientenspulen 34, 35, 36, welche zur Erzeugung von Magnetfeldgradienten in drei voneinander verschiedene Richtungen ausgebildet sind. Die drei voneinander verschiedenen Richtungen sind vorzugsweise orthogonal zueinander. Die Gradientenspuleneinheit 19 kann auch einen Gradientenverstärker und/oder ein den Gradientenverstärker mit einer Gradientenspule verbindendes Gradientenkabel und/oder einen Filter für das Gradientenkabel umfassen.

Die Gradientenspuleneinheit 19 wird mittels einer Gradientensteuereinheit 28 angesteuert. Des Weiteren weist die Magneteinheit 13 eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von dem Hauptmagneten 17 erzeugten Hauptmagnetfeld 18 einstellt, auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein.

Die vom Magnetresonanzgerät 11 umfasste Komponente kann als Gradientenspuleneinheit 19, und/oder als zumindest eine Gradientenspule der Gradientenspulen 34, 35, 36, und/oder als Gradientenverstärker, und/oder als Hochfrequenzantenneneinheit 20, und/oder als Hochfrequenzverstärker, und/oder als Filterplatte und/oder als ein Gradientenkabel und/oder als Hochfrequenzkabel und/oder als ein Teil der genannten ausgebildet sein. Vorzugsweise umfasst die Komponente die Gradientenspuleneinheit 19 und/ein Teil der Gradientenspuleneinheit 19. Die Komponente wird durch eine Zeitkonstante beschrieben, welche Zeitkonstante größer als eine Zeitdauer des ersten Sequenz-Moduls und/oder des zweiten Sequenz-Moduls ist.

Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Zudem umfasst die Steuerungseinheit 24 eine nicht näher dargestellte Rekonstruktionseinheit zu einer Rekonstruktion von medizinischen Bilddaten, die während der Magnetresonanzuntersuchung erfasst werden. Das Magnetresonanzgerät 11 weist eine Anzeigeeinheit 25 auf. Steuerinformationen wie beispielsweise Steuerungsparameter, sowie rekonstruierte Bilddaten können auf der Anzeigeeinheit 25, beispielsweise auf zumindest einem Monitor, für einen Benutzer angezeigt werden.

Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.

Die Steuerungseinheit 24 umfasst weiterhin eine Optimierungseinheit 33. Die Optimierungseinheit 33 ist zudem zu einer Ausführung eines Verfahrens zu einer Optimierung einer zeitlichen Abfolge einer MR-Steuerungssequenz ausgelegt. Hierzu weist die Optimierungseinheit 33 Computerprogramme und/oder Software auf, die direkt in einem nicht näher dargestellten Speichereinheit der Optimierungseinheit 33 ladbar sind, mit Programmmitteln, um ein Verfahren zu einer Optimierung einer zeitlichen Abfolge einer MR-Steuerungssequenz auszuführen, wenn die Computerprogramme und/oder Software in der Optimierungseinheit 33 ausgeführt werden. Die Optimierungseinheit 33 weist hierzu einen nicht näher dargestellten Prozessor auf, der zu einer Ausführung der Computerprogramme und/oder Software ausgelegt ist. Alternativ hierzu können die Computerprogramme und/oder Software auch auf einem getrennt von der Steuerungseinheit 24 und/oder Optimierungseinheit 33 ausgebildeten elektronisch lesbaren Datenträger 21 gespeichert sein, wobei ein Datenzugriff von der Optimierungseinheit 33 auf den elektronisch lesbaren Datenträger 21 über ein Datennetz erfolgen kann.

Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird. Das Magnetresonanzgerät 11 ist somit zusammen mit der Optimierungseinheit 33 zur Ausführung eines erfindungsgemäßen Verfahrens ausgelegt.

Ein Verfahren zu einer Optimierung einer zeitlichen Abfolge einer MR-Steuerungssequenz kann auch in Form eines Computerprogrammprodukts vorliegen, das das Verfahren auf die Optimierungseinheit 33 implementiert, wenn es auf der Optimierungseinheit 33 ausgeführt wird. Ebenso kann ein elektronisch lesbarer Datenträger 21 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 21 in einer Optimierungseinheit 33 eines Magnetresonanzgeräts 11 das beschriebene Verfahren durchführen.

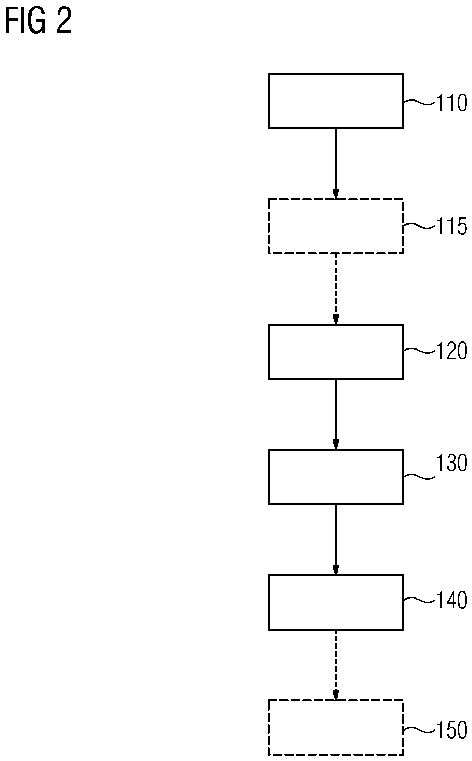

Figur 2 zeigt ein Ablaufdiagramm einer Ausführungsform eines erfindungsgemäßen Verfahrens. Zu Beginn des Verfahrens liegt typischerweise eine zu optimierende MR-Steuerungssequenz vor. Die zu optimierende MR-Steuerungssequenz liegt dabei typischerweise in einer originären Fassung vor, welche originäre MR-Steuerungssequenz nicht an das Magnetresonanzgerät 11 und/oder die Komponente und/oder eine bestimmte Messung und/oder das Untersuchungsobjekt angepasst ist. Gemäß der optimierten MR-Steuerungssequenz und/oder mit der originären MR-Steuerungssequenz kann das Magnetresonanzgerät 11 angesteuert werden. Die originäre MR-Steuerungssequenz umfasst zumindest zwei Sequenz-Module M1, M2. Die zeitliche Abfolge der zumindest zwei Sequenz-Module M1, M2 soll im Rahmen des erfindungsgemäßen Verfahrens optimiert werden. Ein erstes Sequenz-Modul der zumindest zwei Sequenz-Module M1, M2 sei M1, ein zweites Sequenz-Modul der zumindest zwei Sequenz-Module M1, M2 sei M2.

Hierfür wird zunächst in Verfahrensschritt 110 eine Eigenschaft einer vom Magnetresonanzgerät 11 umfassten Komponente ermittelt. In Verfahrensschritt 120 erfolgt die Ermittlung einer ersten Anforderung an die Komponente für das erste Sequenz-Modul M1. In Verfahrensschritt 130 erfolgt die Ermittlung einer zweiten Anforderung an die Komponente für das zweite Sequenz-Modul M2. Die Verfahrensschritte 110, 120, 130 können in beliebiger zeitlicher Reihenfolge und/oder zumindest teilweise simultan ausgeführt werden. In Verfahrensschritt 140 erfolgt die Optimierung der zeitlichen Abfolge der zumindest zwei Sequenz-Module unter Berücksichtigung der Eigenschaft, der ersten Anforderung und der zweiten Anforderung.

Die originäre MR-Steuerungssequenz umfasst typischerweise eine Vielzahl von Sequenz-Modulen. Abhängig von der durchzuführenden Untersuchung kann auf bestimmte Sequenz-Module der Vielzahl von Sequenz-Modulen verzichtet werden. So kann gemäß einer Ausführungsform des Verfahrens optional in Verfahrensschritt 115 eine Selektion der zumindest zwei Sequenz-Module M1, M2 aus einer Vielzahl von Sequenz-Modulen ausgeführt werden. Verfahrensschritt 115 wird typischerweise zeitlich vor den Verfahrensschritten 120 und 130 ausgeführt. Zusätzlich kann optional in einem weiteren Verfahrensschritt 150 die Ansteuerung des Magnetresonanzgeräts 11 mittels der optimierten MR-Steuerungssequenz erfolgen.

Die erste Anforderung kann eine für das erste Sequenz-Modul M1 erforderliche Leistung der Komponente umfassen. Die zweite Anforderung kann eine für das zweite Sequenz-Modul M2 erforderliche Leistung der Komponente umfassen. Die Eigenschaft kann eine Limitierung, insbesondere eine maximale Leistung und/oder eine Belastbarkeit, für die Komponente angeben. Die Optimierung der zeitlichen Abfolge der zumindest zwei Sequenz-Module M1, M2 und/oder der MR-Steuerungssequenz erfolgt typischerweise derart, dass die erste Anforderung und die zweite Anforderung in einem zeitlichen Mittel der Eigenschaft der Komponente gerecht werden. Die Optimierung der zeitlichen Abfolge der zumindest zwei Sequenz-Module M1, M2 und/oder der MR-Steuerungssequenz erfolgt typischerweise derart, dass eine Zeitdauer eines Teiles der MR-Steuerungssequenz umfassend das erste Sequenz-Modul M1 und das zweite Sequenz-Modul M2 und/oder eine gesamte Zeitdauer der MR-Steuerungssequenz reduziert, insbesondere minimiert, wird. Die Optimierung der zeitlichen Abfolge der zumindest zwei Sequenz-Module M1, M2 und/oder der MR-Steuerungssequenz erfolgt typischerweise derart, dass eine Belastung der Komponente aufgrund der ersten Anforderung und aufgrund der zweiten Anforderung in einem zeitlichen Mittel konstant ist. Die Optimierung der zeitlichen Abfolge kann eine Wahl einer Pause umfassen. Das erste Sequenz-Modul M1 kann zu einer ersten Diffusionswichtung ausgebildet sein. Das zweite Sequenz-Modul M2 kann zu einer zweiten Diffusionswichtung ausgebildet sein.

Umfasst die Komponente die Gradientenspuleneinheit 19 mit zumindest zwei der drei Gradientenspulen 34, 35, 36 und umfasst die Eigenschaft der Komponente eine maximale Leistung für die zumindest zwei der drei Gradientenspulen 34, 35, 36, so kann die erste Anforderung eine erste Information bezüglich einer ersten Richtung der voneinander verschiedenen Richtungen umfassen und/oder die zweite Anforderung eine zweite Information bezüglich einer zweiten Richtung der voneinander verschiedenen Richtungen umfassen. Vorzugsweise werden bei der Optimierung der zeitlichen Abfolge die zumindest zwei voneinander verschiedenen Richtungen und/oder die erste Information und/oder die zweite Information berücksichtigt.

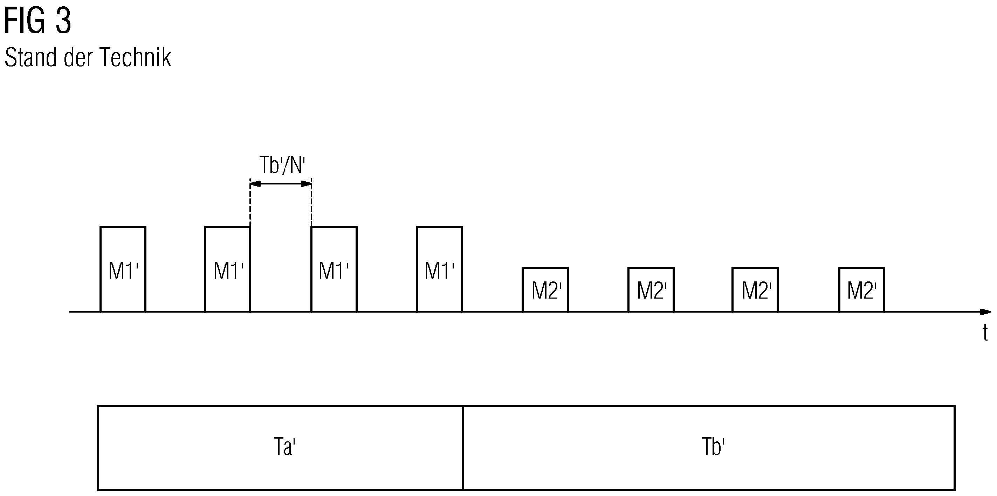

Figur 3 zeigt eine schematische Darstellung einer aus dem Stand der Technik bekannten zeitlichen Abfolge einer MR-Steuerungssequenz, also eine herkömmliche zeitliche Abfolge einer herkömmlichen MR-Steuerungssequenz. Die schematische Darstellung gibt vorzugsweise einen Ausschnitt der herkömmlichen zeitlichen Abfolge der herkömmlichen MR-Steuerungssequenz an. Die herkömmliche MR-Steuerungssequenz kann der originären MR-Steuerungssequenz entsprechen. In Figur 3 wird die zeitliche Abfolge der herkömmlichen Sequenz-Module M1', M2' als Funktion der Zeit t dargestellt. In vertikaler Richtung ist die mit einem Sequenz-Modul verbundene Anforderung an die Komponente, beispielsweise die thermische Belastung der Komponente, insbesondere der Gradientenspuleneinheit 19, angegeben. Zusätzlich visualisiert Figur 3 ein Verhältnis der Aufnahmezeit Ta' zur herkömmlichen Pausenzeit Tb'. Die Aufnahmezeit Ta' gibt die Zeitdauer an, welche Zeitdauer zum Ausspielen der herkömmlichen Sequenz-Module M1', M2' erforderlich ist. Die herkömmliche Pausenzeit Tb' gibt die gesamte Zeitdauer der Pausen an, welche das Ausspielen der herkömmlichen Sequenz-Module M1', M2' in der angegebenen zeitlichen Reihenfolge bedingt, insbesondere um der Eigenschaft der Komponente gerecht zu werden.

Die herkömmliche MR-Steuerungssequenz umfasst eine Vielzahl an Sequenz-Modulen, wobei die Vielzahl durch N' quantifiziert wird und/oder der dargestellte Ausschnitt der herkömmlichen zeitlichen Abfolge N' Sequenz-Module umfasst. Die in Figur 3 dargestellte herkömmliche MR-Steuerungssequenz umfasst vier Sequenz-Module M1' und vier Sequenz-Module M2'. Die Sequenz-Module M1' weisen eine höhere Anforderung an die Komponente auf als die Sequenz-Module M2'. Zwischen zwei zeitlich aufeinanderfolgenden Sequenz-Modulen M1', M2' ist eine Pause der Zeitdauer Tb'/N' angeordnet. Die herkömmliche MR-Steuerungssequenz ist derart ausgestaltet, dass während dieser Pause keine Hochfrequenz-Pulse und/oder Gradientenpulse gespielt werden und/oder MR-Signale aufgenommen werden. Die Zeitdauer Tb'/N' wird typischerweise derart gewählt, dass eine Überlastung der Komponente aufgrund einer thermischen Belastung aufgrund eines Sequenz-Moduls M1' und/oder aufgrund der vier aufeinanderfolgenden Sequenz-Module M1' vermieden wird. Typischerweise beeinflusst die Zeitdauer Tb'/N' zwischen zwei aufeinanderfolgenden Sequenz-Modulen aufgrund von Relaxationseffekten einen Kontrast der zu erzeugenden Bilddaten. Demnach ist es typischerweise vorteilhaft, die zeitliche Abfolge der Sequenz-Module M1', M2' mit einer konstanten Zeitdauer Tb'/N' zwischen zwei aufeinanderfolgenden Sequenz-Modulen M1', M2' zu wählen, insbesondere um Bilddaten mit einem einheitlichen Kontrast zu erzeugen.

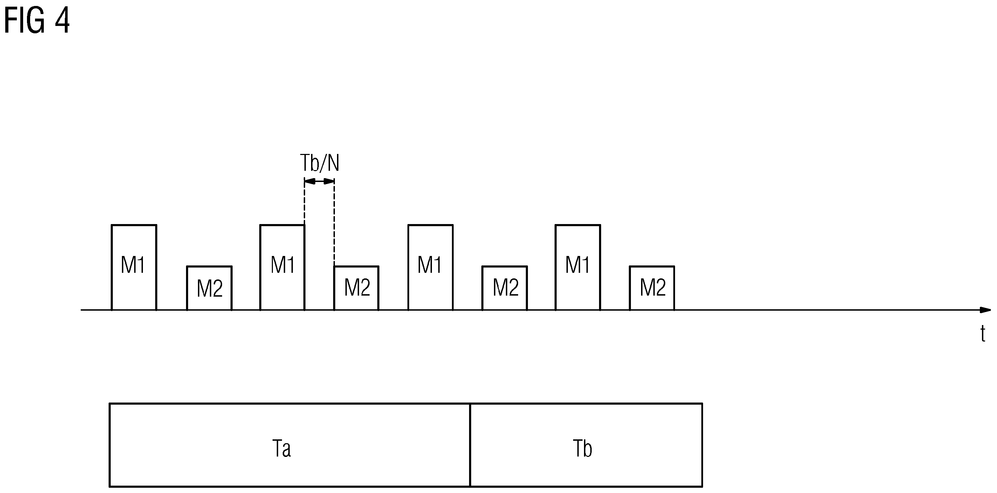

Figur 4 zeigt eine schematische Darstellung einer optimierten zeitlichen Abfolge einer MR-Steuerungssequenz. Die schematische Darstellung gibt vorzugsweise einen Ausschnitt der optimierten zeitlichen Abfolge der MR-Steuerungssequenz an. In Figur 4 wird die optimierte zeitliche Abfolge der Sequenz-Module M1, M2 als Funktion der Zeit t dargestellt. In vertikaler Richtung ist die mit einem Sequenz-Modul verbundene Anforderung an die Komponente, beispielsweise die thermische Belastung der Komponente, insbesondere der Gradientenspuleneinheit 19, angegeben. Zusätzlich visualisiert Figur 4 ein Verhältnis der Aufnahmezeit Ta zur Pausenzeit Tb. Die Aufnahmezeit Ta gibt die Zeitdauer an, welche Zeitdauer zum Ausspielen der Sequenz-Module M1, M2 erforderlich ist. Die Pausenzeit Tb gibt die gesamte Zeitdauer der Pausen an, welche das Ausspielen der Sequenz-Module M1, M2 in der angegebenen zeitlichen Reihenfolge bedingt, insbesondere um der Eigenschaft der Komponente gerecht zu werden.

Die MR-Steuerungssequenz umfasst eine Vielzahl an Sequenz-Modulen, wobei die Vielzahl durch N quantifiziert wird und/oder der dargestellte Ausschnitt der zeitlichen Abfolge N Sequenz-Module umfasst. Die in Figur 4 dargestellte MR-Steuerungssequenz umfasst vier Sequenz-Module M1 und vier Sequenz-Module M2. Die Sequenz-Module M1 weisen eine höhere Anforderung an die Komponente auf als die Sequenz-Module M2. Zwischen zwei zeitlich aufeinanderfolgenden Sequenz-Modulen M1, M2 ist eine Pause der Zeitdauer Tb/N angeordnet. Die MR-Steuerungssequenz ist derart ausgestaltet, dass während dieser Pause keine Hochfrequenz-Pulse und/oder Gradientenpulse gespielt werden und/oder MR-Signale aufgenommen werden. Ein Sequenz-Modul M1 kann einem Sequenz-Modul M1' in Figur 3 entsprechen. Ein Sequenz-Modul M2 kann einem Sequenz-Modul M2' in Figur 3 entsprechen.

Im Folgenden wird anhand eines Beispiels unter Berücksichtigung der Figuren 3 und 4 das erfindungsgemäße Verfahren und dessen Wirkung erläutert.

Die originäre MR-Steuerungssequenz umfasst vorzugsweise vier Sequenz-Module M1 und vier Sequenz-Module M2. Die optimierte zeitliche Abfolge der insgesamt acht Sequenz-Module M1, M2 ist in Figur 4 dargestellt. Die zeitliche Abfolge der insgesamt acht Sequenz-Module M1', M2' in Figur 3 kann der zeitlichen Abfolge der originären MR-Steuerungssequenz entsprechen. Die Sequenz-Module M1 können jeweils zu einer ersten Diffusionswichtung mit einem ersten b-Wert ausgebildet sein. Die Sequenz-Module M2 können jeweils zu einer zweiten Diffusionswichtung mit einem zweiten b-Wert ausgebildet sein. Die Sequenz-Module M1, M2 umfassen vorzugsweise jeweils ein Anregungsmodul, ein Diffusionskodierungsmodul und ein Auslesemodul. Ein Diffusionskodierungsmodul ist charakterisiert durch den b-Wert des Sequenz-Moduls und/oder der Richtung der Diffusionswichtung. Bei Kopfuntersuchungen werden typischerweise zwei oder drei Diffusionswichtungen mit jeweils ein, drei, vier oder mehreren Richtungen verwendet.

Die Komponente umfasst beispielsweise eine Gradientenspuleneinheit 19, vorzugsweise mit einem Gradientenverstärker. Die Eigenschaft der Gradientenspuleneinheit 19 umfasst eine Limitierung, insbesondere einen maximal zulässigen Wert, für die thermische Belastung der Gradientenspuleneinheit 19. Eine thermische Belastung der Gradientenspuleneinheit 19 durch ein Sequenz-Modul ist typischerweise proportional zum b-Wert der von dem Sequenz-Modul erzeugten Diffusionswichtung.

Als erste Anforderung für das Sequenz-Modul M1 an die Komponente wird die thermische Belastung der Gradientenspuleneinheit 19 durch das Sequenz-Modul M1 bestimmt. Es wird also ermittelt, welcher thermischen Belastung die Gradientenspuleneinheit 19 beim Ausspielen des Sequenz-Moduls M1 ausgesetzt ist. Als zweite Anforderung für das Sequenz-Modul M2 an die Komponente wird die thermische Belastung der Gradientenspuleneinheit 19 durch das Sequenz-Modul M2 bestimmt. Es wird also ermittelt, welcher thermischen Belastung die Gradientenspuleneinheit 19 beim Ausspielen des Sequenz-Moduls M2 ausgesetzt ist. Die derart ermittelte zweite Anforderung gilt vorzugsweise für die von der originären MR-Steuerungssequenz umfassten Sequenz-Module M2.

Herkömmliche MR-Steuerungssequenzen für Diffusionsbildgebung weisen eine zeitliche Reihenfolge der Sequenz-Module zur Diffusionswichtung mit typischerweise sukzessiv aufsteigendem b-Wert auf. Gemäß dem Stand der Technik bestimmt der maximale b-Wert innerhalb einer MR-Steuerungssequenz und die mit dem maximalen b-Wert verbundene thermische Belastung die Zeitdauer der Pausen zwischen zwei zeitlich aufeinanderfolgenden Sequenz-Modulen. Die Zeitdauer der Pausen zwischen zwei zeitlich aufeinanderfolgenden Sequenz-Modulen ist vorzugsweise innerhalb einer MR-Steuerungssequenz konstant. Bei herkömmlichen MR-Steuerungssequenzen ist der zeitliche Ablauf der zumindest zwei Sequenz-Module demnach derart ausgestaltet, dass über einen längeren Zeitraum, insbesondere über einen Zeitraum welcher länger als die charakteristische Zeitkonstante der Gradientenspuleneinheit 19 ist, Sequenz-Module mit maximalem b-Wert appliziert werden können. Für die Berechnung einer Pause und damit für die Bestimmung des herkömmlichen zeitlichen Ablaufs der Sequenz-Module ist demnach typischerweise der maximale b-Wert der MR-Steuerungssequenz relevant. Die charakteristische Zeitkonstante der Gradientenspuleneinheit 19 kann von wenigen Millisekunden bis zu mehreren Minuten betragen.

Gemäß dem vorgeschlagenen Verfahren wird vorzugsweise bereits bei der Festlegung der zeitlichen Abfolge der Sequenz-Module M1, M2 die Limitierung der Komponente, also die Limitierung der Gradientenspulen 34, 35, 36, und ein Einfluss der Sequenz-Module M1, M2 auf die Gradientenspulen 34, 35, 36 berücksichtigt. So kann beispielsweise die zeitliche Abfolge der Sequenz-Module M1, M2 umfassend Diffusionswichtungen und deren Richtungen derart gestaltet werden, dass alle Gradientenspulen 34, 35, 36 über den Zeitraum der MR-Steuerungssequenz und/oder über den Zeitraum der gesamten Untersuchung des Patienten möglichst gleichmäßig thermisch belastet werden. Vorzugsweis wird die zeitliche Abfolge derart gewählt, dass die thermische Belastung auch innerhalb der charakteristischen Zeit der Komponente gleichmäßig ist und/oder Abweichungen von maximal 30%, bevorzugt von maximal 15% aufweist. Dadurch kann die erforderliche Pausenzeit Tb/N zwischen zwei zeitlich aufeinanderfolgenden Sequenz-Modulen M1, M2 im Vergleich zur herkömmlichen Pausenzeit Tb'/N' reduziert werden. Folglich kann die für die optimierte MR-Steuerungssequenz erforderliche Pausenzeit Tb im Vergleich zur herkömmlichen Pausenzeit Tb' reduziert werden. Die Aufnahmezeit Ta' der herkömmlichen MR-Steuerungssequenz entspricht der Aufnahmezeit Ta der optimierten MR-Steuerungssequenz, sofern die Sequenz-Module M1 und M1' und die Sequenz-Module M2 und M2' übereinstimmen und die beiden MR-Steuerungssequenzen jeweils die gleiche Anzahl N, N' umfassen. Dadurch wird auch die Gesamtdauer Ta + Tb der optimierten MR-Steuerungssequenz im Vergleich zur Gesamtdauer Ta' + Tb' der herkömmlichen MR-Steuerungssequenz reduziert.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, welcher durch die Ansprüche gegeben ist.

**Patentansprüche**

1. Verfahren zu einer Optimierung einer zeitlichen Abfolge einer MR-Steuerungssequenz,

    gemäß welcher MR-Steuerungssequenz ein Magnetresonanzgerät ansteuerbar ist,
    wobei die MR-Steuerungssequenz zumindest zwei Sequenz-Module aufweist,
    gemäß den folgenden Verfahrensschritten:

       - Erfassen einer Eigenschaft einer vom Magnetresonanzgerät umfassten Komponente umfassend eine Gradientenspuleneinheit umfassend zumindest zwei Gradientenspulen zur Erzeugung von Magnetfeldgradienten in zumindest zwei voneinander verschiedenen Richtungen,
       - Ermittlung einer ersten Anforderung an die Komponente für ein erstes Sequenz-Modul der zumindest zwei Sequenz-Module,
       - Ermittlung einer zweiten Anforderung an die Komponente für ein zweites Sequenz-Modul der zumindest zwei Sequenz-Module,
       - Optimierung der zeitlichen Abfolge der zumindest zwei Sequenz-Module unter Berücksichtigung der Eigenschaft, der ersten Anforderung und der zweiten Anforderung,

    **dadurch gekennzeichnet, dass** die Eigenschaft der Komponente eine maximale Leistung für eine erste der zumindest zwei Gradientenspulen und eine maximale Leistung für eine zweite der zumindest zwei Gradientenspulen umfasst,
    die erste Anforderung eine erste Information bezüglich einer ersten Richtung der zumindest zwei voneinander verschiedenen Richtungen umfasst und die zweite Anforderung eine zweite Information bezüglich einer zweiten Richtung der zumindest zwei voneinander verschiedenen Richtungen umfasst,
    das erste Sequenz-Modul die erste Gradientenspule überdurchschnittlich stark beansprucht und das zweite Sequenz-Modul die zweite Gradientenspule überdurchschnittlich stark beansprucht,
    und bei der Optimierung der zeitlichen Abfolge die zumindest zwei voneinander verschiedenen Richtungen und die erste Information und die zweite Information berücksichtigt werden, wobei in einem weiteren Verfahrensschritt das Magnetresonanzgerät mittels der optimierten MR-Steuerungssequenz angesteuert wird.

2. Verfahren nach Anspruch 1,
    wobei die erste Anforderung eine für das erste Sequenz-Modul erforderliche Leistung der Komponente und/oder die zweite Anforderung eine für das zweite Sequenz-Modul erforderliche Leistung der Komponente umfasst.

3. Verfahren nach einem der vorangehenden Ansprüche, wobei die zeitliche Abfolge derart optimiert wird, dass die erste Anforderung und die zweite Anforderung in einem zeitlichen Mittel die Eigenschaft der Komponente einhält.

4. Verfahren nach einem der vorangehenden Ansprüche, wobei die zeitliche Abfolge derart optimiert wird, dass eine Zeitdauer eines Teiles der MR-Steuerungssequenz umfassend das erste Sequenz-Modul und das zweite Sequenz-Modul und/oder eine gesamte Zeitdauer der MR-Steuerungssequenz minimiert wird.

5. Verfahren nach einem der vorangehenden Ansprüche, wobei die zeitliche Abfolge derart optimiert wird, dass eine Belastung der Komponente aufgrund der ersten Anforderung und aufgrund der zweiten Anforderung in einem zeitlichen Mittel über einen Zeitraum umfassend das erste Sequenz-Modul und das zweite Sequenz-Modul konstant ist.

6. Verfahren nach einem der vorangehenden Ansprüche, wobei die Optimierung der zeitlichen Abfolge ein Einfügen einer Zeitdauer frei von Hochfrequenz-Pulsen und/oder von Gradientenpulsen und/oder von einem Auslesefenster umfasst.

7. Verfahren nach einem der vorangehenden Ansprüche, wobei die Komponente zumindest eines der folgenden Bauteile umfasst:

   - Gradientenverstärker,
   - Gradientenkabel,
   - Hochfrequenzverstärker,
   - Hochfrequenzantenneneinheit,
   - Hochfrequenzkabel,
   - Filterplatte.

8. Verfahren nach einem der vorangehenden Ansprüche, wobei die Komponente durch eine Zeitkonstante beschrieben wird, welche Zeitkonstante größer als eine Zeitdauer des ersten Sequenz-Moduls und/oder des zweiten Sequenz-Moduls ist.

9. Verfahren nach einem der vorangehenden Ansprüche,

wobei das erste Sequenz-Modul zu einer ersten Diffusionswichtung und das zweite Sequenz-Modul zu einer zweiten Diffusionswichtung ausgebildet sind.

10. Verfahren nach einem der vorangehenden Ansprüche, wobei das Verfahren eine Selektion der zumindest zwei Sequenz-Module aus einer Vielzahl von Sequenz-Modulen umfasst.

11. Magnetresonanzgerät umfassend eine Komponente und eine Steuerungseinheit umfassend eine Optimierungseinheit, welche Optimierungseinheit zu einer Ausführung eines Verfahrens zu einer Optimierung einer zeitlichen Abfolge einer MR-Steuerungssequenz nach einem der vorangehenden Ansprüche ausgelegt ist.

12. Computerprogrammprodukt, welches ein Programm umfasst und direkt in einen Speicher einer programmierbaren Optimierungseinheit ladbar ist, mit Programmmitteln, um ein Verfahren zu einer Optimierung einer zeitlichen Abfolge einer MR-Steuerungssequenz nach einem der Ansprüche 1 bis 10 auszuführen, wenn das Programm in der Optimierungseinheit ausgeführt wird.

13. Elektronisch lesbarer Datenträger, auf dem ein Programm hinterlegt ist, das derart ausgestaltet ist, dass das Programm bei Verwendung des Datenträgers in einer Optimierungseinheit das Verfahren zu einer Optimierung einer zeitlichen Abfolge einer MR-Steuerungssequenz nach einem der Ansprüche 1 bis 10 durchführt.

**Claims**

1. Method for optimising a time progression of an MR control sequence,

   according to which MR control sequence a magnetic resonance imager is drivable,
   the MR control sequence having at least two sequence modules, according to the following method steps:

   - detecting a property of a component included in the magnetic resonance imager comprising a gradient control unit comprising at least two gradient coils for generating magnetic field gradients in at least two mutually different directions,
   - determining a first requirement of the component for a first sequence module of the at least two sequence modules,
   - determining a second requirement of the component for a second sequence module of the at least two sequence modules,
- optimising the time progression of the at least two sequence modules, taking account of the property, the first requirement and the second requirement,

**characterised in that** the property of the component comprises a maximum power for a first of the at least two gradient coils and a maximum power for a second of the at least two gradient coils,
the first requirement comprises a first item of information relating to a first direction of the at least two mutually different directions and the second requirement comprises a second item of information relating to a second direction of the at least two mutually different directions,
the first sequence module significantly loads the first gradient coil in an above average manner and the second sequence module significantly loads the second gradient coil in an above average manner,
and, for time progression optimisation, the at least two mutually different directions and the first item of information and the second item of information are taken into account,
wherein in a further method step, the magnetic resonance imager is actuated by means of the optimised MR control sequence.

2. Method according to claim 1,
wherein the first requirement comprises a power of the component required for the first sequence module and/or the second requirement comprises a power of the component required for the second sequence module.

3. Method according to one of the preceding claims, wherein the time progression is optimised in such a way that the first requirement and the second requirement comply with the property of the component over a time-based average.

4. Method according to one of the preceding claims, wherein the time progression is optimised in such a way that the duration of a part of the MR control sequence comprising the first sequence module and the second sequence module and/or an entire duration of the MR control sequence is minimised.

5. Method according to one of the preceding claims, wherein the time progression is optimised in such a way that loading of the component on the basis of the first requirement and on the basis of the second requirement is constant over a duration of a time-based average comprising the first sequence module and the second sequence module.

6. Method according to one of the preceding claims, wherein optimisation of the time progression comprises insertion of a duration free of high frequency pulses and/or of gradient pulses and/or of a read-out window.

7. Method according to one of the preceding claims, wherein the component comprises at least one of the following elements:

   - gradient amplifier,
   - gradient cable,
   - high-frequency amplifier,
   - high-frequency antenna unit,
   - high-frequency cable,
   - filter plate.

8. Method according to one of the preceding claims, wherein the component is described by a time constant, which time constant is greater than a duration of the first sequence module and/or of the second sequence module.

9. Method according to one of the preceding claims, wherein the first sequence module is configured for a first diffusion weighting and the second sequence module for a second diffusion weighting.

10. Method according to one of the preceding claims, wherein the method comprises selection of the at least two sequence modules from a plurality of sequence modules.

11. Magnetic resonance imager comprising a component and a control unit comprising an optimisation unit, which optimisation unit is designed to carry out a method for optimising a time progression of an MR control sequence according to one of the preceding claims.

12. Computer program product which comprises a program and can be loaded directly into a memory of a programmable optimisation unit, having program means for carrying out a method for optimising a time progression of an MR control sequence according to one of claims 1 to 10 when the program is run in the optimisation unit.

13. Electronically readable data storage medium, on which a program is stored, which is designed such that, when the data storage medium is used in an optimisation unit, the program performs the method for optimising a time progression of an MR control sequence according to one of claims 1 to 10.

**Revendications**

1. Procédé d'optimisation d'une suite temporelle d'une séquence de commande RM,

séquence de commande RM suivant laquelle un appareil de résonance magnétique peut être commandé,
dans lequel la séquence de commande RM a au moins deux modules de séquence,
selon les stades de procédé suivants :

- détection d'une propriété d'un composant faisant partie de l'appareil de résonance magnétique et comprenant une unité de bobine de gradient comprenant au moins deux bobines de gradient pour la production de gradients de champ magnétique dans au moins deux directions différentes l'une de l'autre,
- détermination d'une première exigence imposée au composant pour un premier module de séquence des au moins deux modules de séquence,
- détermination d'une deuxième exigence imposée au composant pour un deuxième module de séquence des au moins deux modules de séquence,
- optimisation de la suite temporelle des au moins deux modules de séquence en tenant compte de la propriété, de la première exigence et de la deuxième exigence,

**caractérisé en ce que** la propriété du composant comprend une puissance maximum pour une première des au moins deux bobines de gradient et une puissance maximum pour une deuxième des au moins deux bobines de gradient,
la première exigence comprend une première information en ce qui concerne une première direction des au moins deux directions différentes l'une de l'autre et la deuxième exigence comprend une deuxième information en ce qui concerne une deuxième direction des au moins deux directions différentes l'une de l'autre,
le premier module de séquence sollicite fortement plus que la moyenne la première bobine de gradient et le deuxième module de séquence sollicite fortement plus que la moyenne la deuxième bobine de gradient,
et lors de l'optimisation de la suite temporelle, on prend en compte les au moins deux directions différentes l'une de l'autre et la première information et la deuxième information,
dans lequel dans un autre stade du procédé, on commande l'appareil de résonance magnétique au moyen de la séquence de commande RM optimisée.

2. Procédé suivant la revendication 1, dans lequel la première exigence comprend une puissance, nécessaire pour le premier module de séquence, du composant et/ou la deuxième exigence comprend une puissance, nécessaire pour le deuxième module de séquence, du composant.

3. Procédé suivant l'une des revendications précédentes, dans lequel on optimise la suite temporelle, de manière à ce que la première exigence et la deuxième exigence respectent en moyenne temporelle la propriété du composant.

4. Procédé suivant l'une des revendications précédentes, dans lequel on optimise la suite temporelle, de manière à minimiser une durée d'une partie de la séquence de commande RM, comprenant le premier module de séquence et le deuxième module de séquence et/ou une durée d'ensemble de la séquence de commande RM.

5. Procédé suivant l'une des revendications précédentes, dans lequel on optimise la suite temporelle, de manière à ce qu'une charge du composant, en raison de la première exigence et en raison de la deuxième exigence, soit en moyenne temporelle constante sur un laps de temps, comprenant le premier module de séquence et le deuxième module de séquence.

6. Procédé suivant l'une des revendications précédentes, dans lequel l'optimisation de la suite temporelle comprend une insertion d'une durée sans impulsion de haute fréquence et/ou d'impulsion de gradient et/ou d'une fenêtre de lecture.

7. Procédé suivant l'une des revendications précédentes, dans lequel le composant comprend au moins l'un des composants suivants :

- amplificateur de gradient,
- câble de gradient,
- amplificateur à haute fréquence,
- unité d'antenne à haute fréquence,
- câble à haute fréquence,
- plaque de filtre.

8. Procédé suivant l'une des revendications précédentes, dans lequel on décrit le composant par une constante de temps, laquelle constante de temps est plus grande qu'une durée du premier module de séquence et/ou du deuxième module de séquence.

9. Procédé suivant l'une des revendications précédentes,
dans lequel le premier module de séquence est constitué pour une première pondération de diffusion et le deuxième module de séquence pour une deuxième pondération de diffusion.

10. Procédé suivant l'une des revendications précédentes,
dans lequel le procédé comprend une sélection des au moins deux modules de séquence dans une pluralité de modules de séquence.

11. Appareil de résonance magnétique comprenant un composant et une unité de commande, comprenant une unité d'optimisation, laquelle unité d'optimisation est conçue pour l'exécution d'un procédé d'optimisation d'une suite temporelle d'une séquence de commande RM suivant l'une des revendications précédentes.

12. Produit de programme d'ordinateur, qui comprend un programme et qui peut être chargé directement dans la mémoire d'une unité d'optimisation programmable, comprenant des moyens de programme pour exécuter un procédé d'optimisation d'une suite temporelle d'une séquence de commande RM suivant l'une des revendications 1 à 10, lorsque le programme est exécuté dans l'unité d'optimisation.

13. Support de données déchiffrable électroniquement, sur lequel est mis en mémoire un programme, qui est conformé de manière à ce que le programme exécute, lors de l'utilisation du support de données dans une unité d'optimisation, le procédé d'optimisation d'une suite temporelle d'une séquence de commande RM suivant l'une des revendications 1 à 10.

FIG 1

# FIG 2

# FIG 3

Stand der Technik

EP 3 425 417 B1

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011083204 A1
- DE 102007009204 A1
- DE 102008015261 B4
- US 5786692 A

**In der Beschreibung aufgeführte Nicht-Patentliteratur**

- **FREITAG et al.** Reducing Short Term Gradient Heating by Usage of Adapted Encoding Schemes. *Proceedings of the ISMRM, 19th annual meeting*, 07 May 2011